# EUROPEAN PATENT APPLICATION

(11) **EP 4 589 615 A1**
(43) Date of publication of application: **23.07.2025**
(21) Application number: 24223825.1
(22) Date of filing: 31.12.2024
(51) Int. Cl.: H01H 1/20, H01H 9/08, H01H 13/00, H01H 13/14, H01H 3/02, H01H 9/04

(54) **SWITCH DEVICE WITH WELDING PROTECTIVE PLATE**

(30) Priority: 16.01.2024 TW 113200568 U
(71) Applicant: Switchlab Inc., New Taipei City 24243 (TW); Switchlab (Shanghai) Co., Ltd., Malu Town, Jiading Area Shanghai City (CN); Gaocheng Electronics Co., Ltd, Shenzhen, Guangdong (CN)
(72) Inventor: WU, Chih-Yuan, 24243 New Taipei City (TW); HSU, Wen Bing, 24243 New Taipei City (TW)
(74) Representative: Cabinet Chaillot

(57) **Abstract**

A switch device includes at least one switch module and at least one welding protective plate. The switch module includes an enclosure for receiving a plurality of control terminals and a driving member therein. The control terminals respectively have an end projected from an end or a rear side of the enclosure. The driving member is controllable to change an electrically connected or disconnected state between the control terminals. The welding protective plate is provided on the enclosure at the end from where the control terminals are projected. The projected control terminals further extend through the welding protective plate to be welded to a circuit board. The welding protective plate can withstand a high temperature and is located between the switch module and the circuit board to form a thermal insulation and protection mechanism, protecting the switch module from external deformation and inner damage by the high temperature during welding.

## Description

### FIELD OF THE INVENTION

The present invention relates to a switch module with welding protective plate, and more particularly, to a switch device having a heat-resistant welding protective plate provided between a switch module and a circuit board, and the welding protective plate effectively protects the switch module from internal damage caused by a high temperature during a welding operation.

### BACKGROUND OF THE INVENTION

In the fields of electrical machines, electronics, and automatic control systems, a variety of switch devices is widely used to switch on and off controlled mechanisms. In a relatively traditional assembling manner, the switch devices are mounted on an operating panel with labeling text, and outer terminals (contacts) of the switch devices are electrically connected to the circuit boards or components in the controlled mechanisms using screwed or inserted conductors. However, in consideration of some economical factors, such as maximum space utilization and simplified wiring, it is now popular to directly weld the outer terminals of the switch devices to the circuit boards in many applications.

CN 100362608 discloses a modular electric switch that includes a plurality of switch elements directly arranged on a circuit board. An add-on panel is fitted on a top of the switch elements via a box and a trigger controller similar to a pushbutton is provided on the add-on panel. The trigger controller operates the switch elements to act correspondingly via an internal linking mechanism. However, in practical application, since the switch elements are directly welded to the circuit board, cases of the switch elements tend to deform and mechanisms in the switch elements are possibly damaged due to a high temperature in the process of welding, resulting in loosened linking mechanism and poor electrical contact of the switch elements.

US Patent No. 4968860 discloses a light-emitting type pushbutton switch that includes at least one micro switch and at least one virtual switch directly provided on a circuit board. A box-shaped switch cover is fitted on a top of the pushbutton switch. A base is received in the box-shaped switch cover and a light-emitting element and a pushbutton with a light-pervious (transparent) cap are connected to the base via a plunger. The base is operable using the pushbutton via the plunger to control the micro switch and the virtual switch. Since the micro switch and the virtual switch are directly welded to the circuit board, the pushbutton switch disclosed in US 4968860 also has the same drawbacks as the modular electric switch disclosed in CN 100362608.

In view of the above-mentioned drawbacks in the practical application of the conventional switch devices that are directly connected to a circuit board, it is tried by the inventor to develop an improved switch device.

### SUMMARY OF THE INVENTION

A primary object of the present invention is to provide a switch device with welding protective plate, which includes at least one switch module and at least one welding protective plate capable of withstanding a high temperature during a welding operation. The switch module includes an enclosure for receiving a plurality of control terminals and a driving member therein. The control terminals respectively have an end outward projected beyond an end of the enclosure. The driving member is controllable to change an electrically connected or an electrically disconnected state between the control terminals. The welding protective plate is provided on the enclosure at the end from where the control terminals are outward projected. The outward projected control terminals further extend through the welding protective plate to be welded to a circuit board. The welding protective plate is located between the switch module and the circuit board to serve as a thermal insulation and protection mechanism to protect the switch module from external deformation and internal damage due to the high temperature during the welding operation.

Another object of the present invention is to provide the above switch device with welding protective plate, the driving member of which can drive a movable conducting plate to electrically connect or disconnect the control terminals, and the movable conducting plate and the control terminals can form a normally open or a normally closed state between them. The control terminals are projected from an end or a bottom of the enclosure of the switch module to be welded to the circuit board. Therefore, the switch device can have differently designed overall structure to adapt to different requirements and can therefore have a wide scope of applications.

A further object of the present invention is to provide the above switch device with welding protective plate, which may include a plurality of the switch modules and a pushbutton module all being assembled to a mounting seat to form an assembly of multiple switch modules that are synchronously controllable with only one single pushbutton module. The switch device can further include a light-emitting module also assembled to the mounting seat, such that the light-emitting module and the switch modules can be commonly controlled by the pushbutton module. Therefore, the switch device can be formed of different functional modules to provide a variety of applications.

A still further object of the present invention is to provide the above switch device with welding protective plate, of which the enclosures of the switch modules are respectively provided on two lateral sides with symmetrically arranged and correspondingly shaped male locating section and female locating sections, and the light-emitting module is provided on two lateral sides of its case with symmetrically arranged and correspondingly shaped secondary male locating sections and secondary female locating sections. The switch modules can be fixedly connected together in parallel through engagement of the male locating sections on one switch module with the female locating sections on another adjoining switch module, and the light-emitting module can be fixedly parallelly connected to the switch modules through engagement of the secondary male and female locating sections on the light-emitting module with the female and male locating sections on the adjoining switch modules.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig. 1 is an exploded perspective view of a switch device according to a first embodiment of the present invention;
Fig. 2 is an exploded perspective view of a switch module and a welding protective plate included in the switch device of Fig. 1;
Fig. 3 is an assembled sectional side view of Fig. 2;
Fig. 4 is an exploded perspective view of a light-emitting module included in the switch device of Fig. 1;
Fig. 5 is an assembled sectional side view of the light-emitting module of Fig. 4;
Fig. 6 illustrates the application of the switch device according to the first embodiment of the present invention;
Fig. 7 is an assembled sectional side view of a switch module and a welding protective plate included in a switch device according to a second embodiment of the present invention;
Fig. 8 is an assembled sectional side view of a light-emitting module included in the switch device according to the second embodiment of the present invention;
Fig. 9 is an exploded perspective view of a switch module and a welding protective plate included in a switch device according to a third embodiment of the present invention;
Fig. 10 is an assembled sectional side view of Fig. 9;
Fig. 11 is an assembled sectional side view of a switch module and a welding protective plate included in a switch device according to a fourth embodiment of the present invention;
Fig. 12 is an exploded perspective view of a switch device according to a fifth embodiment of the present invention;
Fig. 13 is an exploded perspective view of a switch module included in a switch device according to the fifth embodiment of the present invention;
Fig. 14 is an assembled perspective view of the switch device according to the fifth embodiment of the present invention;
Fig. 15 illustrates the application of the switch device according to the fifth embodiment of the present invention; and
Fig. 16 is an assembled sectional side view of the switch module and the welding protective plate included in the switch device of Fig. 14.

### DETAILED DESCRIPTION OF THE PREFERRED EMBODIMENTS

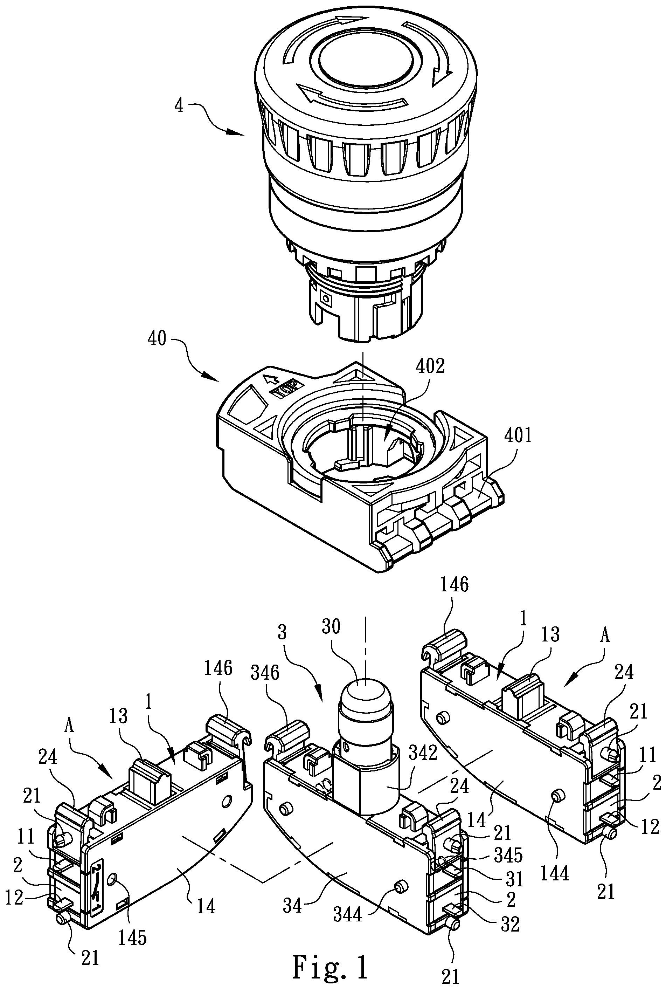

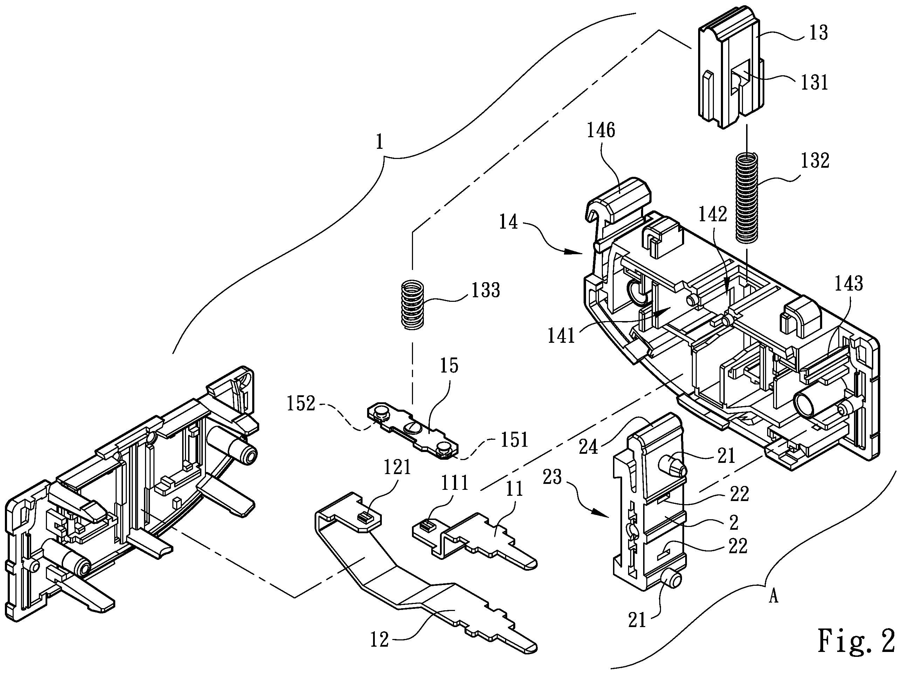

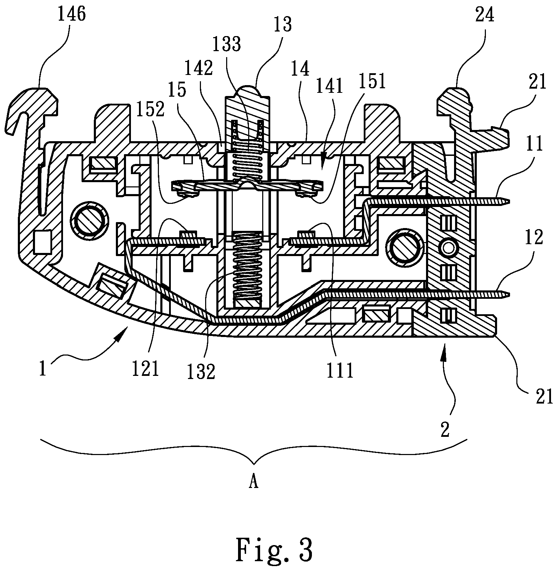

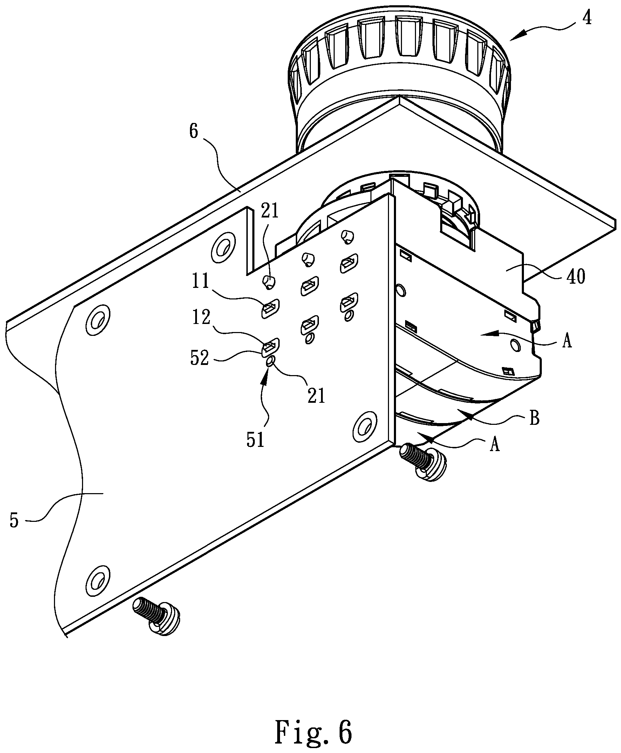

The present invention will now be described with some preferred embodiments thereof and by referring to the accompanying drawings. For the purpose of easy to understand, elements that are the same in the preferred embodiments are denoted by the same reference numerals. Please refer to Figs. 1 to 6, in which a switch device according to a first embodiment of the present invention is shown. In the first embodiment, the switch device is a 90-degree normally open circuit board switch structure, which has a circuit board connected to one end of at least one switch module to extend in parallel to a direction in which the switch is pressed to operate. The switch device in the first embodiment includes a plurality of switch modules 1 and a plurality of welding protective plates 2. Each of the switch modules 1 has an enclosure 14, which internally defines a receiving section 141 for receiving two control terminals 11, 12 and a movable conducting plate 15 therein. The two control terminals 11, 12 respectively have an end provided with a fixed contact 111, 121 and another end extended sideward (when viewing in front of the drawing) relative to the end having the fixed contacts 111, 121 to outward project beyond an end of the enclosure 14 to be weld to welding points 52 on a circuit board 5, as can be seen in Figs. 2, 3 and 6. The receiving section 141 is communicable with an external space via a hollow-out opening 142 provided at a middle portion thereof and a driving member 13 is confined in and partially projected from the hollow-out opening 142. The driving member 13 is provided at a middle portion with a transverse slot 131 that extends through the driving member 13 in a thickness direction thereof, allowing the movable conducting plate 15 to extend through the transverse slot 131 to be located between and at one side of the two fixed contacts 111, 121 closer to the driving member 13. The transverse slot 131 has a second elastic element 133 received therein with a lower end of the second elastic element 133 pressed against the movable conducting plate 15. The movable conducting plate 15 has movable contacts 151, 152 provided thereon corresponding to the fixed contacts 111, 121, respectively. A first elastic element 132 has an upper end pushed against a bottom of the receiving section 141, such that the driving member 13 keeps holding the movable contacts 151, 152 provided on the movable conducting plate 15 to a position away from the two fixed contacts 111, 121 and the two control terminals 11, 12 are in a normally open and electrically disconnected state. When the driving member 13 is subjected to a force applied thereto and is moved, the movable contacts 151, 152 on the movable conducting plate 15 are driven to contact with the two fixed contacts 111, 121, such that the two control terminals 11, 12 are electrically connected to each other under control.

In the first embodiment, the enclosure 14 is provided on one end closer to the circuit board 5 with a coupling section 143, which can be, for example, a dovetail tenon.

Each of the welding protective plates 2 is made of a high-temperature resistant material. The welding protective plate 2 is connected to one end of the enclosure 14, from where the control terminals 11, 12 are outward projected beyond the enclosure 14, and located between the switch module 1 and the circuit board 5. The welding protective plate 2 is provided with terminal slots 22 for the two outward projected control terminals 11, 12 to extend therethrough. The welding protective plate 2 is further provided on one side closer to the circuit board 5 with at least one locating protrusion 21, which is located corresponding to at least one engaging hole 51 provided on the circuit board 5. The circuit board 5 is held to the switch modules 1 via engagement of the locating protrusions 21 with the engaging holes 51.

In the first embodiment, the welding protective plate 2 is provided on one side closer to the enclosure 14 of the switch module 1 with a mating coupling section 23, which can be, for example, a dovetail mortise, for easily and firmly assembling to the coupling section 143 (a dovetail tenon) on the enclosure 14, so that the welding protective plate 2 and the switch module 1 can be correspondingly connected to one another to form a switch component A.

In an operable embodiment, a plurality of switch components A and a pushbutton module 4 can be assembled to a mounting seat 40 while the pushbutton module 4 is fixed to a panel 6, so as to provide an operating control device for controlling the plurality of switch components A using only one single pushbutton module 4. The mounting seat 40 includes a pushbutton mounting hole 402 provided at a central area thereof for the pushbutton module 4 to assemble thereto. The mounting seat 40 is provided on two opposite ends with a plurality of symmetrically arranged retaining sections 401, the enclosure 14 of each switch module 1 is provided on one side having the hollow-out opening 142 with a first locating section 146, and each of the welding protective plates 2 is provided on one side corresponding to the first locating section 146 with a second locating section 24. The first and the second locating sections 146, 24 of the switch components A can be correspondingly hooked to the retaining sections 401 on the mounting seat 40, such that the switch components A are fixedly connected to the mounting seat 40.

In the above structure, the enclosure 14 is provided on one lateral outer side with at least one male locating section 144, such as at least one protruded boss, and on an opposite lateral outer side with at least one female locating section 145, such as at least one recess. With this arrangement, two adjacent switch components A can be fixedly connected to each other through engagement of the at least one male locating section 144 on a first switch component A with the at least one female locating section 145 on the other adjoining switch component A.

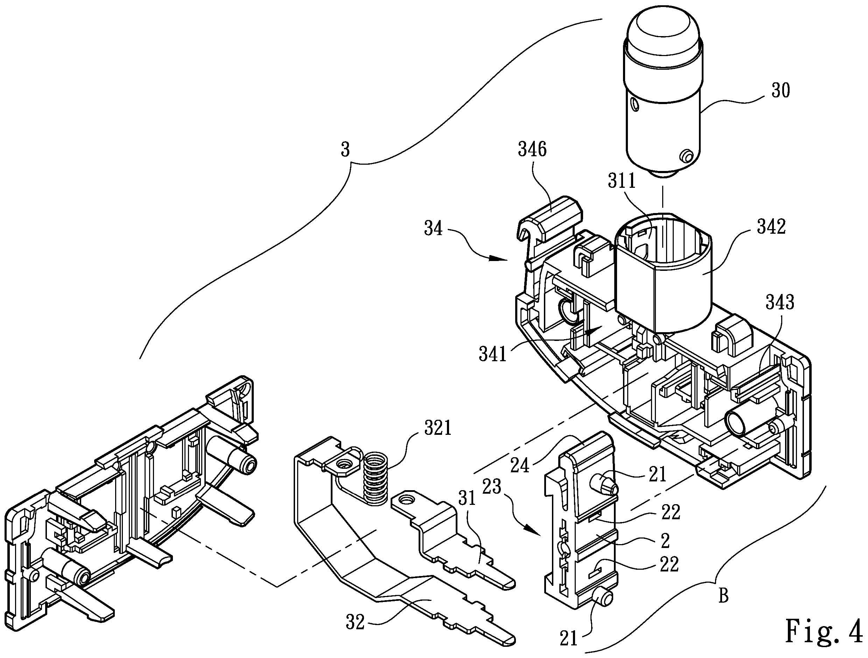

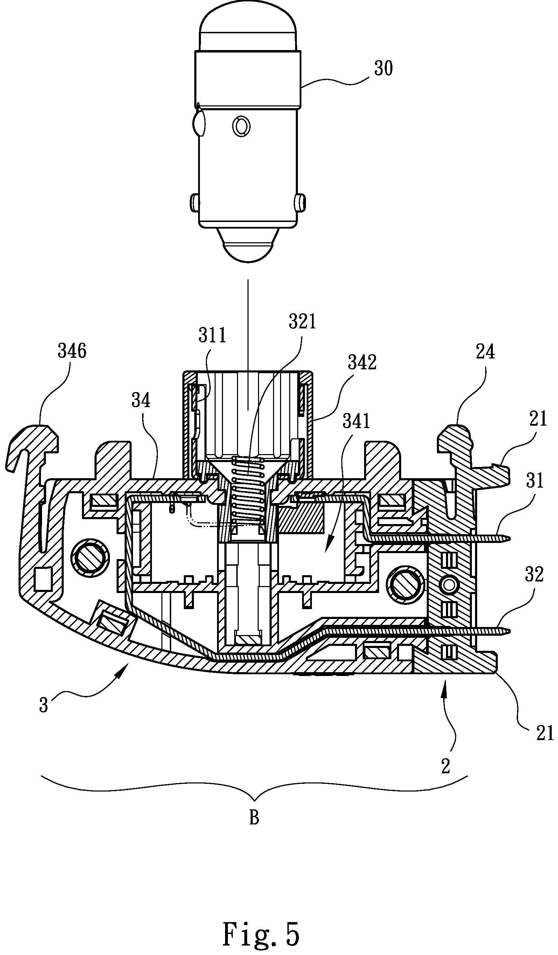

In practical application of the switch device according to the first embodiment of the present invention, the mounting seat 40 may also have a plurality of switch components A and a light-emitting module 3 assembled thereto. As shown in Fig. 4, the light-emitting module 3 includes a case 34, which has a configuration similar to the enclosure 14 of the switch module 1 and internally defines a receiving section 341 for receiving two conducting terminals 31, 32 therein. The two conducting terminals 31, 32 respectively have an end extended toward and outward projected beyond one end of the case 34, as can be seen in Fig. 5, to be welded to the welding points 52 on the circuit board 5. The receiving section 341 is provided at a top middle portion with a light-emitting element assembling seat 342, which is communicable with a space outside the case 34 and allows a light-emitting element 30 to be fitted therein. The light-emitting element assembling seat 342 is internally provided with a conducting section 311, which is in contact with an outer circumferential surface of the light-emitting element 30 that serves as a negative electrode. The conducting section 311 is electrically connected to the conducting terminal 31. A bottom of the light-emitting element 30 serves as a positive electrode, which is electrically connected to the conducting terminal 32 via an elastic conducting element 321, such that the light-emitting element 30 is connectable to an external power source via the two conducting terminals 31, 32. The case 34 is provided with a third locating section 346, at least one secondary male locating section 344, and at least one secondary female locating section 345 (see Fig. 1), which are structurally configured corresponding to the first locating section 146, the at least one male locating section 144, and the at least one female locating section 145, respectively.

Similarly, a welding protective plate 2 is provided at the end of the case 34 of the light-emitting module 3, from where the conducting terminals 31, 32 are projected to an outer side of the case 34, and the welding protective plate 2 is located between the light-emitting module 3 and the circuit board 5. The end of the case 34 facing toward the welding protective plate 2 is provided with a coupling section 343, such as a dovetail tenon, for engaging with the mating coupling section 23, such as a dovetail mortise, provided on the welding protective plate 2, so that the light-emitting model 3 and the welding protective plate 2 are assembled to each other to form a light-emitting component B. The two outward projected conducting terminals 31, 32 respectively pass through one terminal slot 22 formed on the welding protective plate 2 to be welded to weld points 52 provided on the circuit board 5. To connect the light-emitting component B to the switch components A, simply engage the secondary male locating sections 344 on one lateral side of the light-emitting component B with the female locating sections 145 on an adjoining switch component A and engage the secondary female locating sections 345 on the other lateral side of the light-emitting component B with the male locating sections 144 on another adjoining switch component A, such that the light-emitting component B is parallelly assembled to and located between two switch components A. Then, hook the third locating section 346 and the second locating section 24 of the light-emitting component B to the retaining sections 401 on the mounting seat 40, such that the light-emitting component B and the switch components A are fixedly connected to the mounting seat 40 simultaneously to form a normally open circuit board switch structure with a light source.

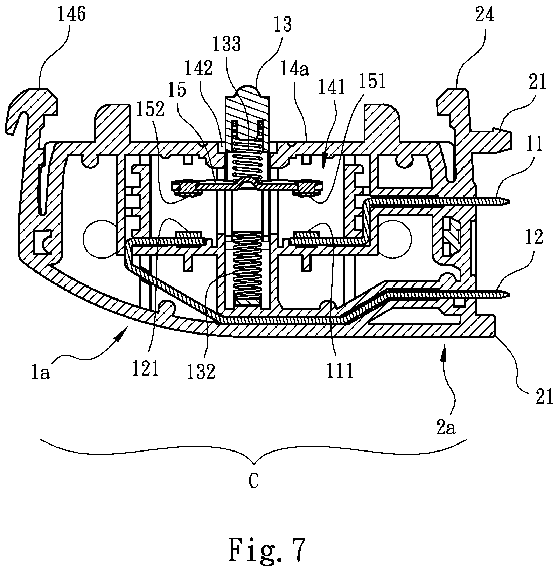

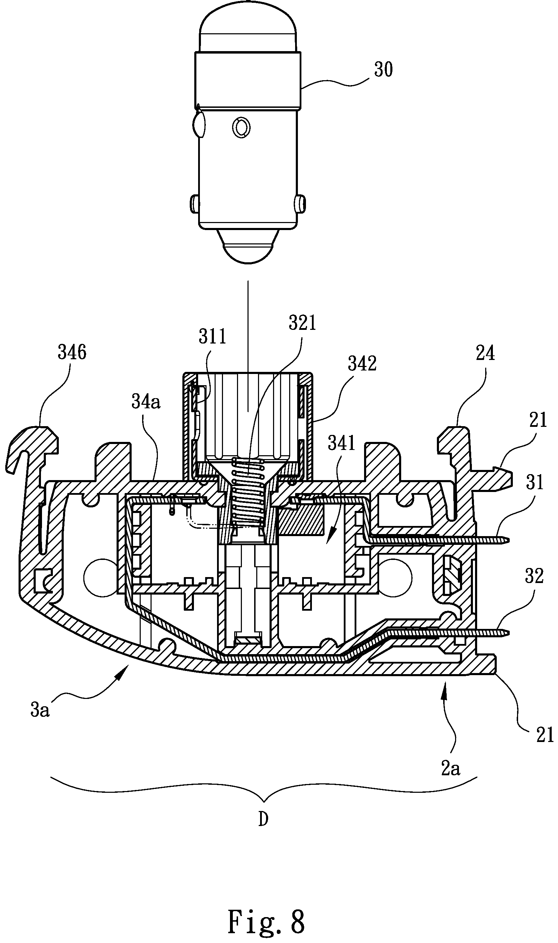

Please refer to Figs. 7 and 8, in which a switch device according to a second embodiment of the present invention is shown. The switch device in the second embodiment is another 90-degree normally open circuit board switch structure, which includes a plurality of switch module 1a and a plurality of welding protective plate 2a. Each of the switch modules 1a includes an enclosure 14a and a driving member 13, two control terminals 11, 12, and a movable conducting plate 15 that are structurally the same as those in the first embodiment. The enclosure 14a is structurally similar to the enclosure 14 in the first embodiment except it does not have any structure like the coupling section 143.

Like the first embodiment, the welding protective plate 2a in the second embodiment also includes locating protrusions 21 and terminal slots 22 and is made of the same high-temperature resistant material, except it does not have any structure like the mating coupling section 23. Further, the welding protective plate 2a and the enclosure 14a of the switch module 1a are integrally formed to provide a switch component C having an integral structural body and including a switch module 1a and a welding protective plate 2a. Since the connection of the switch component C to the circuit board 5 and the use of a mounting seat 40 to assemble a plurality of the switch components C all are the same as those in the first embodiment, they are not repeatedly described herein.

In practical application of the switch device according to the second embodiment of the present invention, one light-emitting module 3a and a plurality of switch components C can be firmly assembled to one mounting seat 40 simultaneously. The light-emitting module 3a includes a case 34a and two conducting terminals 31, 32, a conducting section 311, an elastic conducting element 321, and a light-emitting element 30 that are the same as those in the first embodiment. The case 34a is structurally similar to the case 34 except it does not have any structure similar to the coupling section 343 on the case 34 and the welding protective plate 2a and the case 34a are integrally formed to provide an integral structural body. The integrally formed light-emitting module 3a and welding protective plate 2a provides a light-emitting component D. Since the connection of the light-emitting component D with the circuit board 5 is the same as that in the first embodiment, it is not repeatedly described herein.

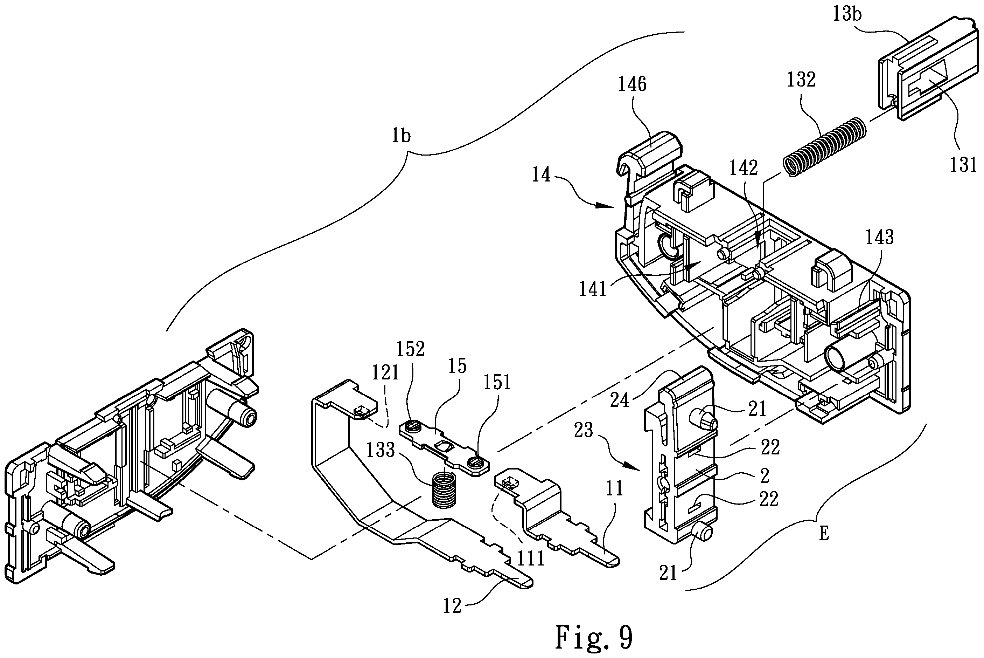

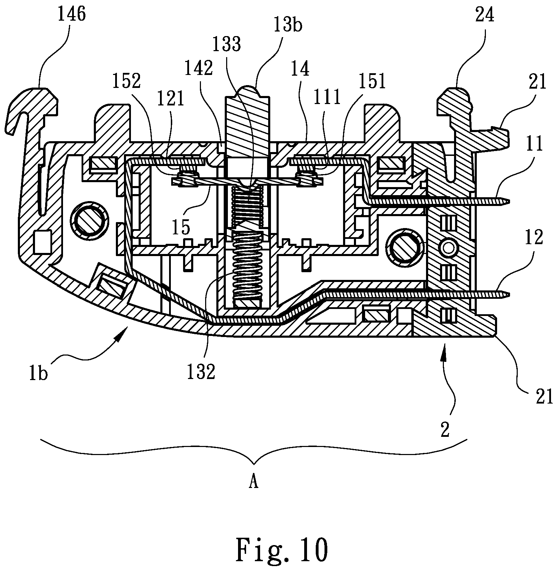

Please refer to Figs. 9 and 10, in which a switch device according to a third embodiment of the present invention is shown. The switch device in the third embodiment is a 90-degree normally closed circuit board switch structure, which includes a switch module 1b and a welding protective plate 2. The switch module 1b includes a driving member 13b, and an enclosure 14, two control terminals 11, 12, and a movable conducting plate 15 that are the same as those in the first embodiment. The driving member 13b is upward extended through the hollow-out opening 142 provided on the enclosure 14 to outward protrude from the enclosure 14 and is provided at a middle section with a transverse slot 131 that extends through the driving member 13 in a thickness direction thereof, allowing the movable conducting plate 15 to extend through the transverse opening 131 to be located between and at one side of the two fixed contacts 111, 121 farther away from of the driving member 13. The transverse slot 131 has a second elastic element 133 received therein with an upper end of the second elastic element 133 pressed against the movable conducting plate 15. A first elastic element 132 is pressed against a bottom of the receiving section 141, such that the driving member 13b keeps holding the movable conducting contacts 151, 152 on the movable conducting plate 15 to a position in contact with the two fixed contacts 111, 121, so that the two control terminals 11, 12 are in a normally closed and accordingly electrically connected state. When the driving member 13b is subjected to a force applied thereto and is moved, the movable contacts 151, 152 on the movable conducting plate 15 are driven to separate from the two fixed contacts 111, 121, such that the two control terminals 11, 12 are electrically disconnected from each other under control.

The welding protective plate 2 in the third embodiment is located between and connected to the switch module 1b and the circuit board 5 in the same manner as that in the first embodiment, and the switch module 1b and the welding protective plate 2 together form a switch component E.

In practical application of the switch device according to the third embodiment of the present invention, the switch component E can be assembled with the pushbutton module 4, the switch component A, and the light-emitting component B via the mounting seat 40 to thereby provide a switch assembly structure being controllable in multiple different modes.

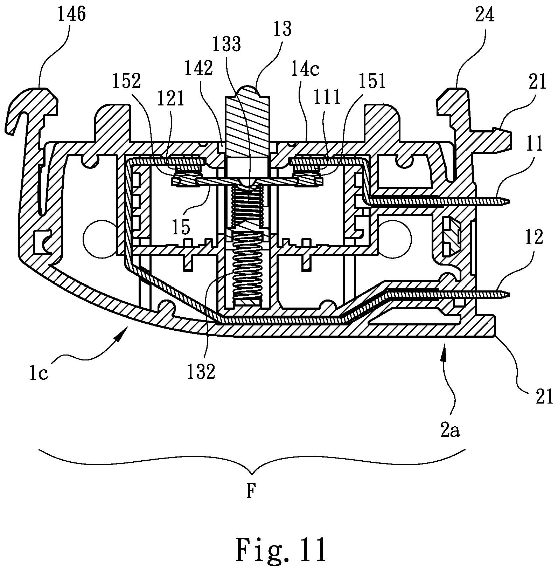

Please refer to Fig. 11, in which a switch device according to a fourth embodiment of the present invention is shown. The switch device in the fourth embodiment is another 90-degree normally closed circuit board switch structure, which includes at least one switch module 1c and at least one welding protective plate 2a. The switch module 1c includes an enclosure 14c, and a driving member 13b, two control terminals 11, 12, and a movable conducting plate 15 the same as those in the third embodiment. The enclosure 14c is structurally similar to the enclosure 14 except it does not have any structure like the coupling section 143.

The welding protective plate 2a includes a locating protrusion 21 and terminal slots 22 the same as those in the first embodiment except it does not have any structure like the mating coupling section 23. Further, the welding protective plate 2a and the enclosure 14c of the switch module 1c are integrally formed to provide an integral structural body, such that the integrally formed switch module 1c and welding protective plate 2a forms a switch component F. In addition, the switch component F and the circuit board 5 are connected to each other in the same manner as that in the third embodiment. Since a plurality of the switch components F can be assembled to one single mounting seat 40 as in the third embodiment, it is not repeatedly described herein.

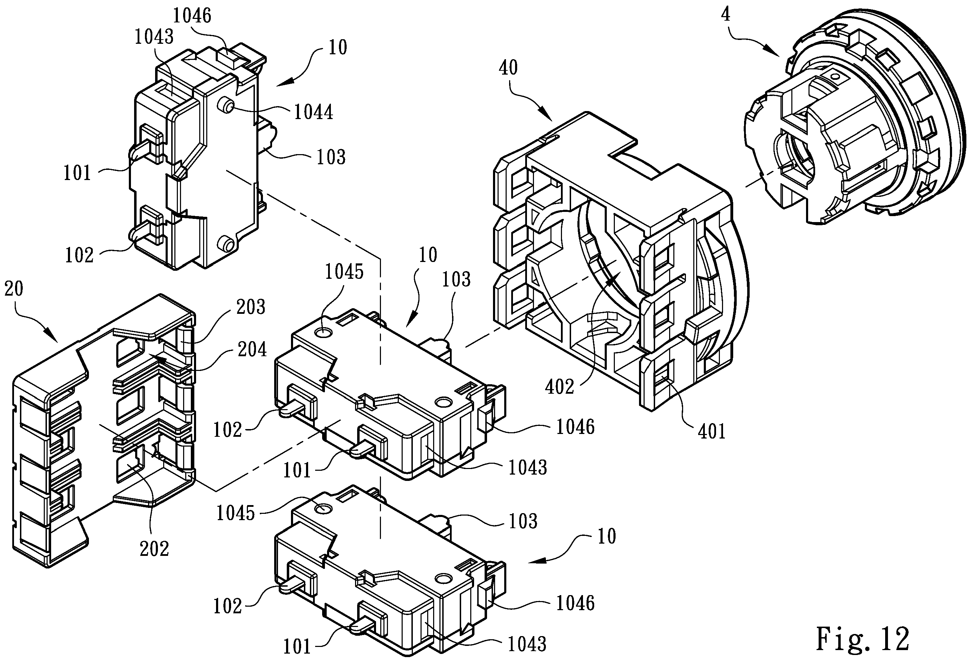

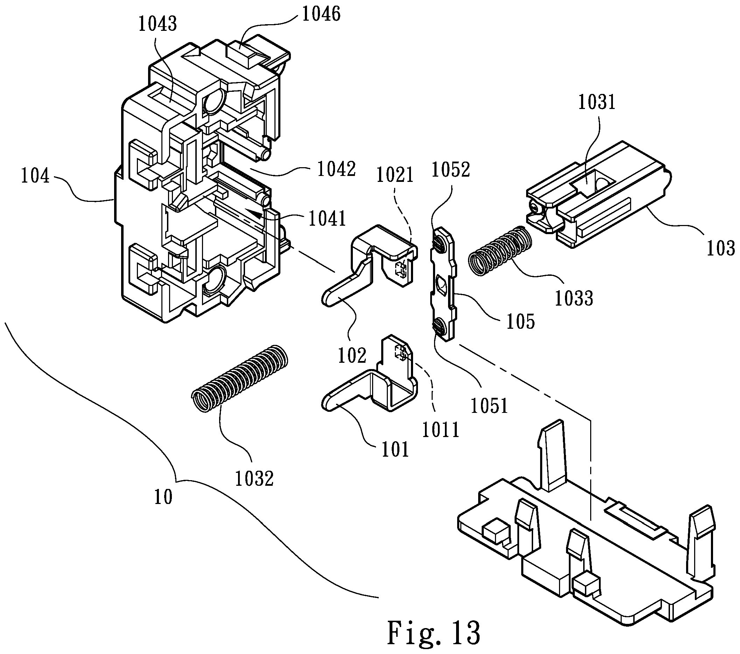

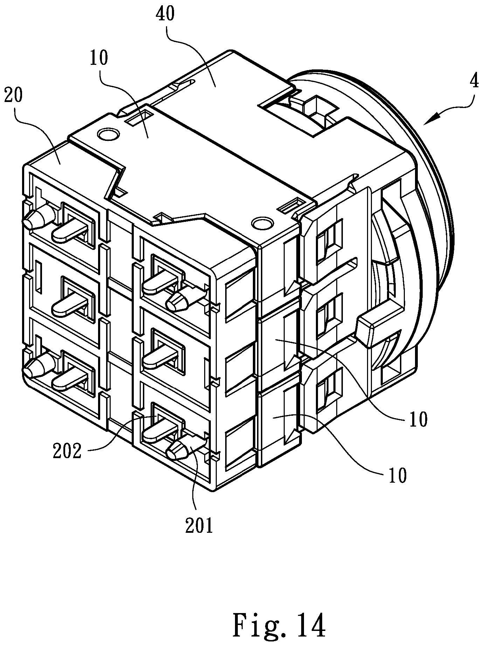

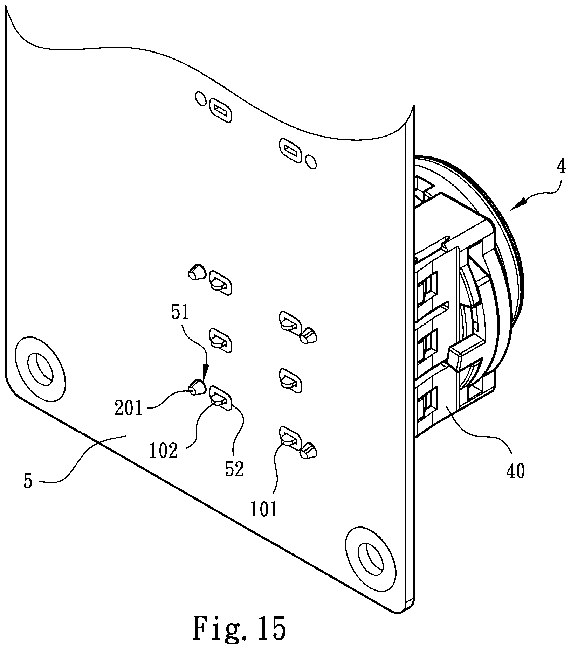

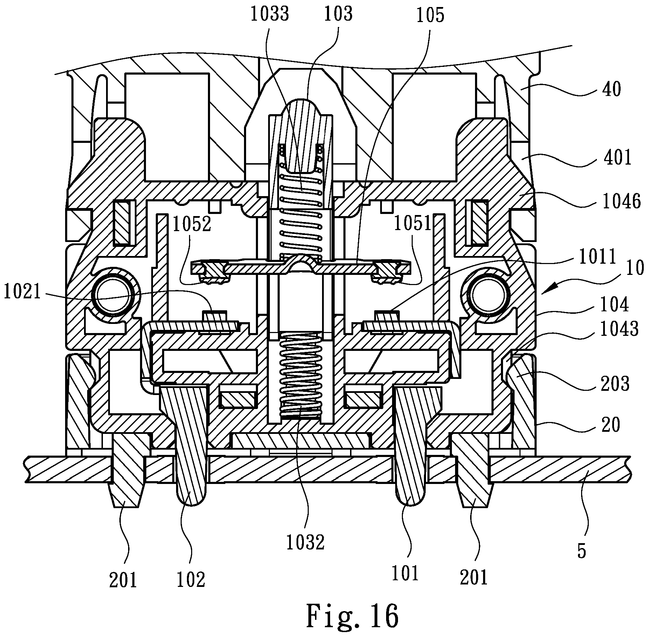

Please refer to Figs. 12 to 16, in which a switch device according to a fifth embodiment of the present invention is shown. The switch device in the fifth embodiment is a 180-degree normally open circuit board switch structure, which has a circuit board connected to a rear side of a switch module to extend perpendicular to a direction in which the switch is pressed to operate. The switch device in the fifth embodiment includes a plurality of switch modules 10 and a welding protective plate 20. Each of the switch modules 10 includes an enclosure 104, which internally defines a receiving section 1041 for receiving two control terminals 101, 102 and a movable conducting plate 105 therein. The two control terminals 101, 102 respectively have an end provided with a fixed contact 1011, 1021 and another end extended backward relative to the fixed contact 1011, 1021 (when viewing in front of the drawing) to outward project beyond the rear side of the enclosure 104 to be welded to welding points 52 on the circuit board 5. The receiving section 1041 is communicable with an external space via a hollow-out opening 1042, which is formed at a front middle portion of the receiving section 1041. A driving member 103 is confined in and partially protruded from the hollow-out opening 1042. The driving member 103 is provided at a middle portion with a transverse slot 1031 that extends through the driving member 103 in a thickness direction thereof, allowing the movable conducting plate 105 to extend through the transverse slot 1031 to be located at one side of the two fixed contacts 1011, 1021 closer to the driving member 103. The transverse slot 1031 has a second elastic element 1033 received therein with an end of the second elastic element 1033 pressed against the movable conducting plate 105. The movable conducting plate 105 has movable contacts 1051, 1052 provided thereon corresponding to the fixed contacts 1011, 1012, respectively. A first elastic element 1032 has an end pushed against a bottom of the receiving section 1041, such that the driving member 103 keeps holding the movable contacts 1051, 1052 provided on the movable conducting plate 105 to a position away from the two fixed contacts 1011, 1021 and the two control terminals 101, 102 are in a normally open and electrically disconnected state. When the driving member 103 is subjected to a force applied thereto and is moved, the movable contacts 1051, 1052 on the movable conducting plate 105 are driven to contact with the two fixed contacts 1011, 1021, such that the two control terminals 101, 102 are electrically connected to each other under control.

In the fifth embodiment, the enclosure 104 is provided at two front corners with two first locating sections 1046, such as two projected hooks, and at two rear corners with two coupling sections 1043, such as two recesses.

The welding protective plate 20 is made of a high-temperature resistant material. The welding protective plate 20 is located at the rear sides of the enclosures 104, from where the control terminals 101, 102 are outward projected beyond the enclosures 104 to be located between the switch modules 10 and the circuit board 5. The welding protective plate 20 is provided with a receiving space 204 for receiving and contacting with the rear sides of the enclosures 104. The receiving space 204 is provided with terminal slots 202 for the two control terminals 101, 102 on each of the switch modules 10 to outward extend therethrough. The welding protective plate 20 is further provided on one side closer to the circuit board 5 with at least one locating protrusion 201 for engaging with engaging holes 51 correspondingly formed on the circuit board 5, such that the welding protective plate 20 is firmly connectable to the circuit board 5 through engagement of the locating protrusions 201 with the engaging holes 51.

In the fifth embodiment, the welding protective plate 20 is provided at two lateral inner sides with a plurality of mating coupling sections 203 corresponding to the coupling sections 1043. The mating coupling sections 203 may be respectively a protrusion. The switch modules 10 and the welding protective plate 20 can be easily assembled to each other through engagement of the mating coupling sections 203 with the coupling sections 1043 to provide a firmly assembled structure.

In an operable embodiment, a plurality of the switch modules 10 and one pushbutton module 4 can be assembled to a mounting seat 40 to form an operating control device for controlling the plurality of switch modules 10 with only one single pushbutton module 4. The mounting seat 40 has a pushbutton mounting hole 402 provided at a central area thereof for a pushbutton module 4 to assemble thereto. The mounting seat 40 is symmetrically provided on two lateral sides with a plurality of retaining sections 401. The switch modules 10 can be firmly connected to the mounting seat 40 through engagement of the first locating sections 1046 with the retaining sections 401 to provide an assembled structure, the switch modules 10 of which can be synchronously operated using the pushbutton module 4.

In practical application of the switch device according to the fifth embodiment of the present invention, the control terminals 101, 102 of the switch modules 10 can be changed in configuration and the movable conducting plates 105 in the switch modules 10 can be changed in position, and the first elastic elements 1032, the second elastic elements 1033 and the driving members 103 of the switch modules 10 can be linked to move in different manners similar to the linking manner used in the third embodiment, such that the two control terminals 101, 102 in each of the switch modules 10 always keep in a normally closed and electrically connected state; and the driving member 103 subjected to a force can cause the movable conducting plate 105 to disconnect the electrically connected state between the control terminals 101, 102. In this way, the switch device according to the fifth embodiment can easily form a 180-degree normally closed circuit board switch structure.

According to the above discussion, the switch device with welding protective plate according to the present invention can indeed achieve the effect of preventing internal mechanisms of the switch device from being damaged by the high temperature during the welding process. Therefore, the present invention meets the requirements of novelty and improvement for granting a patent. It is also understood the present invention has been described with some preferred embodiments thereof and it is understood that many changes, modifications, alterations or equivalent substitutes in the described embodiments can be carried out without departing from the scope and the spirit of the invention that is intended to be limited only by the appended claims.

## Claims

1. A switch device with welding protective plate, comprising at least one switch module (1, 10, 1a, 1b, 1c), which includes an enclosure (14, 104, 14a, 14c) for receiving a plurality of control terminals (11, 12; 101, 102) and a driving member (13, 103, 13b) therein, and the driving member (13, 103, 13b) being partially protruded from the enclosure (14, 104, 14a, 14c) and being controllable to change an electrically connected or electrically disconnected state between the control terminals (11, 12; 101, 102); the switch device being **characterized in that** the control terminals (11, 12; 101, 102) respectively have an end outward projected beyond one end of the enclosure (14, 104, 14a, 14c); and that
at least one welding protective plate (2, 20, 2a) capable of withstanding a high temperature during a welding operation is provided on the end of the enclosure (14, 104, 14a, 14c), from where the control terminals (11, 12; 101, 102) are projected beyond the enclosure (14, 104, 14a, 14c).

2. The switch device with welding protective plate as claimed in claim 1, wherein the enclosure (14, 104) is provided on the end facing toward the welding protective plate (2, 20) with at least one coupling section (143, 1043), and the welding protective plate (2, 20) being provided on one side facing toward the enclosure (14, 104) with at least one mating coupling section (23, 203) for engaging with the at least one coupling section (143, 1043) correspondingly, such that the welding protective plate (2, 20) and the switch module (1, 10, 1b) can be fixedly connected to each other through engagement of the at least one mating coupling section (23, 203) with the at least one coupling section (143, 1043).

3. The switch device with welding protective plate as claimed in claim 1, wherein the welding protective plate (2a) and the enclosure (14a, 14c) are integrally formed to provide an integral structural body.

4. The switch device with welding protective plate as claimed in claim 1, wherein the welding protective plate (2, 20, 2a) allows one end of the control terminals (11, 12; 101, 102) to project therefrom.

5. The switch device with welding protective plate as claimed in any one of claims 1 to 4, wherein the control terminals (11, 12) are outward projected beyond at least one side of the enclosure (14, 14a, 14c) that is extended in parallel to a direction in which the switch module (1, 1a, 1b, 1c) is pressed to operate.

6. The switch device with welding protective plate as claimed in any one of claims 1 to 4, wherein the control terminals (101, 102) are outward projected beyond a rear end of the enclosure (104) that is extended perpendicular to a direction in which the switch module (10) is pressed to operate.

7. The switch device with welding protective plate as claimed in any one of claims 1 to 6, wherein the enclosure (14, 104, 14a, 14c) further has a movable conducting plate (15, 105) received therein; the movable conducting plate (15, 105) being associated with the driving member (13, 103, 13b) to be located between and at one side of the control terminals (11, 12; 101, 102) closer to the driving member (13, 103); the driving member (13, 103) being pushed by a first elastic element (132, 1032) to be located in the enclosure (14, 104, 14a), such that the driving member (13, 103) keeps holding the movable conducting plate (15, 105) to a position away from the control terminals (11, 12; 101, 102) and the control terminals (11, 12; 101, 102) are in a normally open and electrically disconnected state; and the movable conducting plate (15, 105) being movable by a downward force applied thereto to thereby contact with the control terminals (11, 12; 101, 102), allowing the control terminals (11, 12; 101, 102) to be electrically connected to each other.

8. The switch device with welding protective plate as claimed in any one of claims 1 to 7, wherein the enclosure (14, 104, 14a, 14c) further has a movable conducting plate (15, 105) received therein; the movable conducting plate (15, 105) being associated with the driving member (13, 103, 13b) to be located between and at one side of the control terminals (11, 12) farther away from the driving member (13b); the driving member (13b) being pushed by a first elastic element (132) to be located in the enclosure (14, 14c), such that the driving member (13b) keeps holding the movable conducting plate (15) to a position in contact with the control terminals (11, 12) and the control terminals (11, 12) are in a normally closed and electrically connected state; and the movable conducting plate (15) being movable by a downward force applied to the driving member (13b) to thereby move away from the control terminals (11, 12), causing the control terminals (11, 12) to be electrically disconnected from each other.

9. The switch device with welding protective plate as claimed in any one of claims 1 to 8, wherein the welding protective plate (2, 20, 2a) is provided with a plurality of terminal slots (22, 202) for the control terminal (11, 12; 101, 102) to correspondingly extend therethrough to be welded to a circuit board (5); and one side of the welding protective plate (2, 20, 2a) facing toward the circuit board (5) being provided with at least one locating protrusion (21, 201) for engaging with at least one engaging hole (51) correspondingly formed on the circuit board (5), such that the welding protective plate (2, 20, 2a) can be held to the circuit board (5) through engagement of the at least one locating protrusion (21, 201) with the at least one engaging hole (51).

10. The switch device with welding protective plate as claimed in any one claims 1 to 9, wherein the at least one switch module (1, 10, 1a 1b, 1c) is connected to a pushbutton module (4) via a mounting seat (40); the mounting seat (40) being provided on outer sides with a plurality of retaining sections (401), the enclosure (14, 104, 14a, 14c) of each switch module (1, 10, 1a 1b, 1c) being provided with a first locating section (146, 1046), and each welding protective plate (2, 20, 2a) being provided with a second locating section (24); and the first locating section (146, 1046) and the second locating section (24) being connectable to the retaining sections (401) on the mounting seat (40), such that the at least one switch module (1, 10, 1a, 1b, 1c) and the at least one welding protective plate (2, 20, 2a) can be simultaneously assembled and fixedly connected to the mounting seat (40).

11. The switch device with welding protective plate as claimed in claim 10, wherein the mounting seat (40) allows a plurality of switch modules (1, 10, 1a, 1b, 1c) to be assembled thereto; the enclosures (14, 14a, 14c) of the switch modules (1, 10, 1a, 1b, 1c) being provided on one of two lateral sides with a plurality of male locating sections (144) and on the other lateral side with a plurality of female locating sections (145); the female locating sections (145) being located and shaped corresponding to the male locating sections (144), such that the male locating sections (144) on one switch module (1, 1a, 1b, 1c) can be engaged with the female locating sections (145) on another adjoining switch module (1, 1a, 1b, 1c) for the switch modules (1, 1a, 1b, 1c) to connect with each other.

12. The switch device with welding protective plate as claimed in claim 11, further comprising a light-emitting module (3, 3a), which is also assembled to the mounting seat (40); the light-emitting module (3, 3a) including a case (34, 34a) having a plurality of conducting terminals (31, 32) received therein; the conducting terminals (31, 32) being respectively connected to one of two electrodes of a light-emitting element (30) and respectively having an end outward projected beyond an end of the case (34, 34a); the case (34, 34a) being provided with a third locating section (346), which is located corresponding to the first locating sections (146, 1046) on the enclosures (14, 104, 14a, 14c); one welding protective plate (2, 2a) being provided between the light-emitting module (3, 3a) and the circuit board (5), the ends of the conducting terminals (31, 32) projected beyond the case (34, 34a) further extending through the welding protective plate (2, 2a) to be welded to the circuit board (5); the light-emitting module (3, 3a) being connected to the retaining sections (401) of the mounting seat (40) via the third locating section (346) of the light-emitting module (3, 3a) and the second locating section (24) of the welding protective plate (2, 2a), such that an assembly of the light-emitting module (3, 3a) and the welding protective plate (2, 2a) can be fixedly assembled to the mounting seat (40).

13. The switch device with welding protective plate as claimed in claim 12, wherein the light-emitting module (3, 3a) is provided on one of two lateral sides with a plurality of secondary male locating sections (344) for correspondingly engaging with the female locating sections (145) of an adjoining enclosure (14, 104, 14a, 14c) and on the other lateral side with a plurality of secondary female locating sections (345) for correspondingly engaging with the male locating sections (144) of another adjoining enclosure (14, 104, 14a, 14c), such that the light-emitting module (3, 3a) and the switch modules (1, 1a, 1b, 1c) can be fixedly connected to one another.

14. The switch device with welding protective plate as claimed in claim 12, wherein the case (34) has at least one coupling section (343) provided on one end facing toward the welding protective plate (2); and the at least one coupling section (343) being connectable to a mating coupling section (23, 203) provided on the welding protective plate (2).

15. The switch device with welding protective plate as claimed in claim 12, wherein the case (34a) and the welding protective plate (2a) are integrally formed to provide an integral structural body.
